# EUROPÄISCHE PATENTSCHRIFT

(11) **EP 1 453 115 B1**
(45) Veröffentlichungstag und Bekanntmachung des Hinweises auf die Patenterteilung: **19.10.2005**
(21) Anmeldenummer: 03004043.0
(22) Anmeldetag: 25.02.2003
(51) Int. Cl.: H01L 41/09, F16K 31/00

(54) **Mit Biegeaktor ausgestattete Aktoreinrichtung**
Actuator apparatus comprising bending actuator
Dispositif muni d'un actionneur à flexion

(43) Veröffentlichungstag der Anmeldung: 01.09.2004
(73) Patentinhaber: FESTO AG & Co, 73734 Esslingen (DE); Argillon GmbH, 96257 Redwitz (DE)
(72) Erfinder: Weinmann, Michael, Dr., 73655 Plüderhausen (DE); Maichl, Martin, 73084 Salach (DE); Munz, Gebhard, 73614 Schorndorf (DE); Schlaak, Helmut, Prof.Dr., 64372 Ober-Ramstadt (DE); Schmid, Andreas Joseph, 96247 Michelau (DE)
(74) Vertreter: Abel, Martin

(56) Entgegenhaltungen:
- WO-A-01/89004
- DE-A- 3 833 157
- DE-A- 19 957 953
- GB-A- 2 329 514
- US-A- 5 068 567

## Beschreibung

Die Erfindung betrifft eine Aktoreinrichtung, mit einem längliche Gestalt aufweisenden Biegeaktor, der mit einem Befestigungsabschnitt an einem Grundkörper der Aktoreinrichtung fixiert ist und der über einen von dem Befestigungsabschnitt wegragenden Arbeitsabschnitt verfügt, der durch Aktivierung des Biegeaktors quer zu dessen Längsachse auslenkbar und gegen einen im Auslenkweg angeordneten Widerstand drückbar ist und der mit mindestens einer zur Erfassung der Längsdehnung geeigneten Sensoreinrichtung ausgestattet ist.

Biegeaktoren sind in der Regel so aufgebaut, dass sie an einem Befestigungsabschnitt fixiert werden können und über einen frei endenden Arbeitsabschnitt verfügen, der durch Anlegen einer Bertriebsspannung biegbar und somit quer zur Längsrichtung auslenkbar ist. Die am meisten verwendeten Vertreter solcher Biegeaktoren sind Piezo-Biegewandler, wie sie beispielsweise aus der WO 01/89004 A1 hervorgehen. Häufig werden sie, wie ebenfalls in der WO 01/89004 A1 beschrieben, als Bestandteile von Aktoreinrichtungen eingesetzt, die als Fluidsteuerventile ausgebildet sind und bei denen der Arbeitsabschnitt verschwenkbar ist, um einen Fluidkanal wahlweise freizugeben oder zu verschließen.

In der WO 01/89004 A1 erfolgt die Beschreibung einer Aktoreinrichtung der eingangs zitierten Art, wobei der Biegeaktor im Bereich des Arbeitsabschnittes mit mindestens einer Sensoreinrichtung ausgestattet ist, die in der Lage ist, die Längsdehnung des Arbeitsabschnittes zu erfassen. Auf diese Weise soll eine Überwachung und/oder Rückmeldung des Betriebsverhaltens des Biegeaktors ohne externe Sensorik durchführbar sein. Bei der praktischen Verwirklichung haben sich jedoch nicht unbeträchtliche Probleme herausgestellt.

Piezokeramische Biegewandler besitzen aufgrund der piezokeramischen Eigenschaften Hysterese- und Drifteffekte. Die Hysterese bedingt, dass bei anliegender Betriebsspannung in Abhängigkeit von der vorausgegangenen Betriebshistorie unterschiedliche Auslenkungen des Biegeaktors möglich sind. Hinzu kommen vor allem mechanische und thermische Drifteffekte, die sich überlagern und in zeitlicher Betrachtung eine Änderung der Biegung und Auslenkung zur Folge haben. Darüber hinaus führen unterschiedliche externe Kräfte, welche auf den Biegeaktor einwirken, ebenfalls zu unterschiedlichsten Biegungen und Auslenkungen. So können, um den Fluidkanal eines Steuerventils zu verschließen, in Abhängigkeit von den herrschenden Drücken unterschiedlich hohe Stellkräfte erforderlich sein, die jeweils, bei gleicher Auslenkung, unterschiedliche Biegeverformungen des Biegeaktors zur Folge haben. Dies bedeutet, dass die gemäß WO 01/89004 A1 am Biegeaktor vorgesehene Sensoreinrichtung nicht ohne weiteres ein reproduzierbares Messergebnis liefern kann.

Man hat auch schon versucht, die Hystereseeffekte bei piezokeramischen Biegewandlern durch die Entwicklung hysteresearmer Piezokeramiken zu reduzieren. Dies führt allerdings zu einem Rückgang der Leistungsfähigkeit der Piezokeramik.

Es ist die Aufgabe der vorliegenden Erfindung, Maßnahmen zu treffen, die eine exakte Erfassung des Betriebsverhaltens eines Biegeaktors ermöglichen.

Diese Aufgabe wird bei einer Aktoreinrichtung der eingangs genannten Art dadurch gelöst, dass die Sensoreinrichtung an und/oder in Längsrichtung symmetrisch beidseits einer Stelle platziert ist, an der bei gegen einen Widerstand drückendem Arbeitsabschnitt eine von der Stellkraft unabhängige, konstante Längsdehnung vorliegt.

Berechnungen haben ergeben, dass der Arbeitsabschnitt eines Biegeaktors eine in Längsrichtung zum Befestigungsabschnitt beabstandete Stelle aufweist, an der die auftretende Längsdehnung unabhängig davon konstant bleibt, mit welcher Kraft der aktivierte Arbeitsabschnitt gegen einen in seinem Auslenkweg platzierten Widerstand gedrückt wird. Wie an den anderen Stellen steigt zwar auch bei dieser speziellen Stelle die Dehnung zunächst an, wenn der Arbeitsabschnitt, ohne auf einen Widerstand zu treffen, durch entsprechende Aktivierung mehr und mehr ausgelenkt wird. Sobald der Arbeitsabschnitt jedoch auf einen Widerstand trifft, beispielsweise auf einen einem Fluidkanal zugeordneten Ventilsitz, ändert sich die Längsdehnung an der fraglichen Stelle nicht mehr, auch wenn die interne Stellkraft des Biegeaktors weiter erhöht wird. Der konstante Dehnungswert ist ein spezifischer Wert des betreffenden Biegeaktors, der auch von der Betriebshistorie nicht beeinflusst wird.

Berechnungen bei unterschiedlichen Biegeaktoren haben ergeben, dass der Abstand der Stelle konstanter Längsdehnung zum Befestigungsabschnitt in der Regel ein Drittel des Abstandes zwischen dem Befestigungsabschnitt und dem mit dem Widerstand zusammenarbeitenden Beaufschlagungsabschnitt beträgt, wenn dieser vorgenannte Abstand im Verhältnis zur Länge des Befestigungsabschnittes relativ groß ist.

Idealerweise würde die Sensoreinrichtung direkt und ausschließlich an der Stelle der konstanten Längsdehnung platziert werden. Da es jedoch konstruktiv sehr schwierig ist, eine entsprechend miniaturisierte Sensoreinrichtung bereitzustellen, wird die Sensoreinrichtung in der Regel so angeordnet sein, dass sie in der Längsrichtung des Biegeaktors symmetrisch zu beiden Seiten der Stelle konstanter Längsdehnung platziert ist, wobei sie an der Stelle konstanter Längsdehnung entweder durchgehend ausgebildet ist oder auch unterbrochen sein kann. Es kann dann eine Integration bzw. Summenbildung über die Messstreckenlängen beidseits der Stelle konstanter Längsdehnung erfolgen, wobei sich über die Gesamtsumme die Auslenkung des Biegeaktors unabhängig von der herrschenden Stellkraft ermitteln lässt und wobei ferner die Möglichkeit besteht, durch Subtraktion der beiden Teildehnungsintegral die aktuell herrschende Stellkraft zu ermitteln. Auf Basis der Erfindung können Biegeaktoren im Closed-Loop-Betrieb, unabhängig von externen Kräften, exakt positioniert werden. Darüber hinaus ist die Auslenkung des Arbeitsabschnittes und die externe Kraft messbar.

Für die Erfindung ergeben sich vielfältige Anwendungen in allen Bereichen, bei denen mittels eines Biegeaktors Stellkräfte auf eine beliebige Struktur ausgeübt werden sollen. Eine mögliche Anwendung ist der Einsatz bei Fluidsteuerventilen, um die Schaltstellung eines als Betätigungsglied und/oder unmittelbar als Ventilglied eingesetzten Biegeaktors präzise erfassen zu können.

Vorteilhafte Weiterbildungen der Erfindung gehen aus den Unteransprüchen hervor.

Bevorzugt ist die Sensoreinrichtung an einer der beiden in der Auslenkungsrichtung orientierten Oberflächen des Arbeitsabschnittes des Biegeaktors platziert.

Um ein mehrfaches Sensorsignal und damit eine höhere Genauigkeit zu erzielen, können gleichzeitig mehrere Sensoreinrichtungen vorgesehen sein, die insbesondere, bezogen auf die Dickenrichtung des Biegeaktors, in unterschiedlichen Ebenen platziert sind und die sich vorzugsweise an beiden einander entgegengesetzten, in der Auslenkungsrichtung orientierten Oberflächen des Biegeaktors befinden.

Wie schon kurz erwähnt, kann sich die Sensoreinrichtung durchgehend, ohne Unterbrechung, über die Stelle konstanter Längsdehnung hinweg erstrecken. Möglich ist allerdings auch eine Bauform, bei der die Sensoreinrichtung im Bereich der Stelle konstanter Längsdehnung unterbrochen ist und sich insbesondere aus zwei Sensoreinrichtungsteilen zusammensetzt, die in Längsrichtung des Biegeaktors mit Abstand zueinander angeordnet sein können. Der Abstand der beiden Sensoreinrichtungsteile von der Stelle konstanter Längsdehnung ist gleich groß und auch die wirksamen Längen der beiden Sensoreinrichtungsteile entsprechen sich.

Die Sensoreinrichtung basiert beispielsweise auf kapazitivem Messprinzip, kann aber auch auf einem ohmschen Widerstandsmessprinzip basieren. Bevorzugt kommen Dehnungsmessstreifen zum Einsatz.

Bei einem Biegeaktor vorgegebener Länge hängt die Position der Stelle konstanter Längsdehnung ersichtlich von der Position des Befestigungsabschnittes ab, also davon, wo und über welche Länge hinweg der Biegeaktor ortsfest eingespannt wird. Da in vielen Fällen diese Einsatzbedingungen bei der Herstellung des Biegeaktors noch nicht bekannt sein werden, kann der Biegeaktor mit einer Sensoreinrichtung ausgestattet sein, die sich über eine längere Strecke entlang dem Biegeaktor ausdehnt und die zur Anpassung an die sich später ergebende Position der Stelle konstanter Längsdehnung selektiv deaktivierbar ist, um die erforderliche symmetrische Gestaltung bezüglich der Stelle konstanter Längsdehnung zu erhalten. Beispielsweise kann die Sensoreinrichtung mittels Laser oder einer anderen Trennvorrichtung so durchtrennt werden, dass sich die gewünschte Symmetrie bezüglich der konstanten Dehnungsstelle ergibt. Die Aktoreinrichtung kann daher mit einer entsprechend selektiv deaktivierten Sensoreinrichtung ausgestattet sein.

Eine mit dem Biegeaktor ausgestattete Aktoreinrichtung kann beispielsweise einen Antrieb bilden, um ein Bauteil, beispielsweise das Ventilglied eines Ventils, in unterschiedlichen Stellungen zu positionieren. Die Aktoreinrichtung kann aber auch unmittelbar als Fluidsteuerventil ausgebildet sein, insbesondere auf dem Sektor der Pneumatik. Auf jeden Fall ist es von Vorteil, wenn die Aktoreinrichtung über Auswertemittel verfügt, durch die die Auslenkung und/oder die Stellkraft des Arbeitsabschnittes auf Basis der durch die Sensoreinrichtung erfassten Dehnung ermittelt werden kann.

Nachfolgend wird die Erfindung anhand der beiliegenden Zeichnung näher erläutert. In dieser zeigen:
- Fig. 1a: in schematischer Darstellung ein Ausführungsbeispiel einer mit einem Biegeaktor ausgestatteten erfindungsgemäßen Aktoreinrichtung in Gestalt eines Fluidsteuerventils,
- Fig. 1b: eine Draufsicht auf den Biegeaktor in Blickrichtung gemäß Pfeil I aus Fig. 1a,
- Fig. 1c: ein Diagramm, das den über der wirksamen Länge L aufgetragenen Verlauf der Längsdehnung e zeigt,
- Fig. 2a bis 2e: die spannungsabhängige Kennlinie des Biegewandlers der Fig. 1a und 1b mit der Längsdehnung e als Funktion der wirksamen Biegeaktorlänge L, wobei schraffiert das Integral über die Messstreckenlänge der Sensoreinrichtung symmetrisch zur Stelle konstanter Längsdehnung aufgezeigt ist,
- Fig. 3: die der Fig. 2e entsprechende Kennlinie, wobei schraffiert die beiden Dehnungsteilintegrale unter den beidseits der Stelle konstanter Längsdehnung liegenden Abschnitten der Sensoreinrichtung gekennzeichnet sind, und
- Fig. 4: einen zur variablen Auslegung der Sensoreinrichtung geeigneten Biegeaktor in einer Einzeldarstellung in Draufsicht vergleichbar der Darstellung in Fig. 1b.

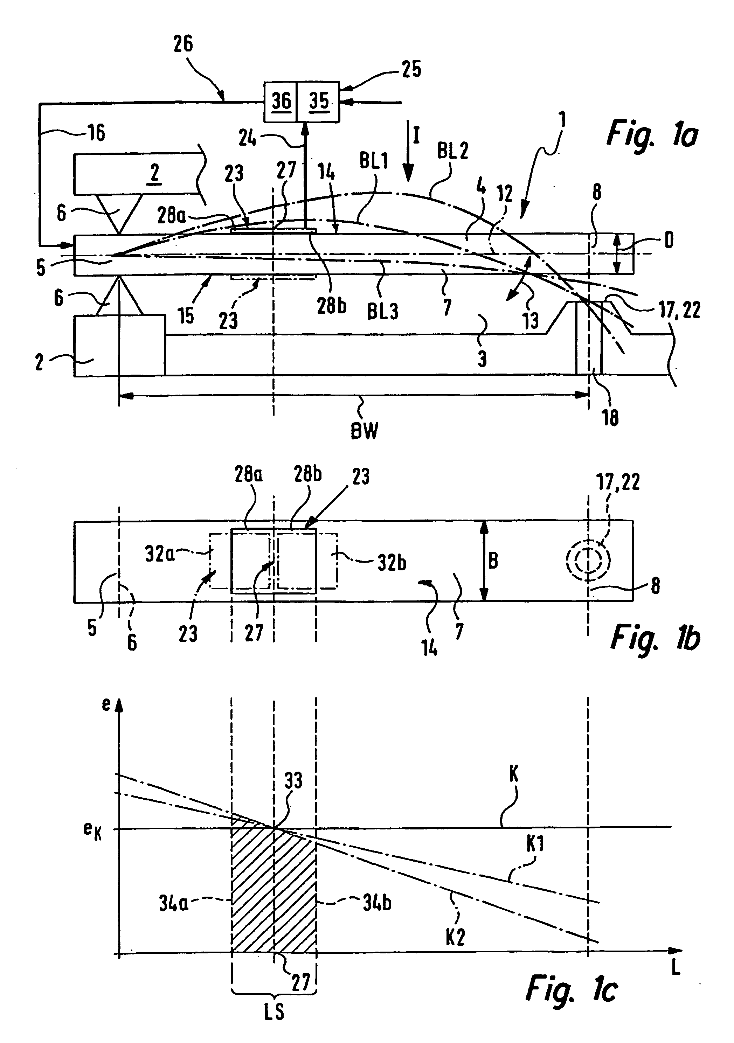

Aus Fig. 1a und 1b geht schematisch eine Aktoreinrichtung 1 hervor, die hier exemplarisch als Fluidsteuerventil ausgebildet ist.

Die Aktoreinrichtung 1 verfügt über einen ein- oder mehrteiligen Grundkörper 2, der vorliegend das Ventilgehäuse bildet und der eine Aufnahmekammer 3 definiert, in der ein längliche Gestalt aufweisender Biegeaktor 4 platziert ist.

Der Biegeaktor 4 ist leisten- oder balkenähnlich gestaltet. Seine Breite B ist in der Regel größer als seine Dicke D.

Einer der beiden axial orientierten Endbereiche des Biegeaktors 4 bildet einen Befestigungsabschnitt 5. Dieser dient zur ortsfesten Fixierung des Biegeaktors 4 an dem Grundkörper 2.

Schematisch ist angedeutet, wie der Befestigungsabschnitt 5 zwischen zwei gehäusefesten Lagerstellen 6 an dem Befestigungsabschnitt 5 fest eingespannt ist. Die Einspannung erfolgt in der Regel so, dass der Befestigungsabschnitt 5 bezüglich der Lagerstellen 6 nicht verschwenkbar ist. Die Lagerstellen 6 können unmittelbare Bestandteile des Grundkörpers 2 sein oder können auch beispielsweise von einem ausgehärteten, im Grundkörper 2 eingebetteten Gießharz gebildet sein.

Von dem Befestigungsabschnitt 5 ragt ein frei endender Arbeitsabschnitt des Biegeaktors 4 weg. Dessen dem Befestigungsabschnitt 5 entgegengesetzter Endbereich bildet einen Beaufschlagungsabschnitt 8.

Bei dem Biegeaktor 4 handelt es sich um ein Bauteil, dessen Arbeitsabschnitt 7 durch entsprechende Aktivierung eine Biegung erfährt und quer zur Längsachse 12 des Biegeaktors 4 auslenkbar ist. Die Auslenkbewegung ist durch einen Doppelpfeil bei 13 angedeutet. Die beiden größerflächigen längsseitigen Oberflächen des im Querschnitt bevorzugt rechteckförmig gestalteten Biegeaktors 4 sind in der Richtung der Auslenkbewegung 13 orientiert und beim Ausführungsbeispiel, lediglich zur besseren Unterscheidung, als obere und untere Oberflächen 14, 15 bezeichnet. Die Fig. 1b ermöglicht einen Blick auf die obere Oberfläche 14.

Der Biegeaktor 4 könnte beispielsweise ein Bimetall- oder Memorymetall-Biegeaktor sein. Beim Ausführungsbeispiel handelt es sich um einen Piezo-Biegewandler, der unter Verwendung einer handelsüblichen Piezokeramik oder sonstiger geeigneter piezoelektrischer Materialien aufgebaut ist.

Im deaktivierten Ausgangszustand nimmt der Biegeaktor 4 die in Fig. 1a in durchgezogenen Linien gezeigte Strecklage mit linearer Ausdehnung ein. Durch Anlegen einer Betriebsspannung über schematisch angedeutete Zuleitungsmittel 16 kann eine Auslenkung des Arbeitsabschnittes 7 hervorgerufen werden, sodass dieser in Richtung zu einem der unteren Oberfläche 15 gegenüberliegenden Ventilsitz 17 verschwenkt wird, der im Auslenkweg des Arbeitsabschnittes 7 und, genauer gesagt, im Auslenkweg des Beaufschlagungsabschnittes 8 liegt.

Der Ventilsitz 17 umgrenzt die Mündung eines insbesondere zumindest teilweise die Wandung des Grundkörpers 2 durchsetzenden Fluidkanals 18, über den im Betrieb des Fluidsteuerventils ein unter einem bestimmten Arbeitsdruck stehendes Fluid zuführbar ist, wobei es sich sowohl um ein hydraulisches als auch um ein gasförmiges Fluid handeln kann. Bevorzugt handelt es sich bei dem Fluid um Druckluft.

Der Ventilsitz 17 bildet einen im Auslenkweg des Arbeitsabschnittes 7 liegenden Widerstand 22, an den der Beaufschlagungsabschnitt 8 angedrückt wird, sodass der Fluidkanal 18 dicht verschlossen wird. Auf diese Weise kann das Einströmen des Fluides in die Aufnahmekammer 3 verhindert werden.

Im deaktivierten Zustand des Biegeaktors 4 ist der Beaufschlagungsabschnitt 8 von dem Ventilsitz 17 abgehoben, sodass Druckmedium über den Fluidkanal 18 in die Aufnahmekammer 3 einströmen und von dort über einen weiteren, ebenfalls in die Aufnahmekammer 3 einmündenden, in der Zeichnung jedoch nicht näher dargestellten Fluidkanal abströmen kann. Auf diese Weise kann die Aktoreinrichtung zum Beispiel als 2/2- oder 3/2-Wegeventil ausgebildet sein.

Der Biegeaktor 4 ist im Bereich des Arbeitsabschnittes 7 mit einer beim Ausführungsbeispiel unmittelbar an der oberen Oberfläche 14 angebrachten Sensoreinrichtung 23 ausgestattet. Diese ist über eine geeignete elektrische Verbindung 24 an schematisch angedeutete elektronische Auswertemittel 25 angeschlossen, die zu einer insgesamt mit Bezugsziffer 26 bezeichneten elektronischen Steuereinrichtung gehören, über die die Ansteuerung des Biegeaktors 4 mit der gewünschten Betriebsspannung erfolgt. Anhand der Sensoreinrichtung 23 lässt sich die momentane Auslenkung des Arbeitsabschnittes 7 erfassen, wobei insbesondere die Möglichkeit besteht, das Erreichen der an dem Widerstand 22 anliegenden Endstellung zu erfassen, und zwar unabhängig von der Stellkraft, mit der der Arbeitsabschnitt 7 gegen den körperlichen Widerstand 22 andrückt.

Die Sensoreinrichtung 23 ist ausgebildet, um die Längsdehnung des Arbeitsabschnittes 7 in dem mit ihr bestückten Bereich zu erfassen. Die erfasste Dehnung ist ein Maß für die aktuelle Auslenkung des Biegeaktors 4.

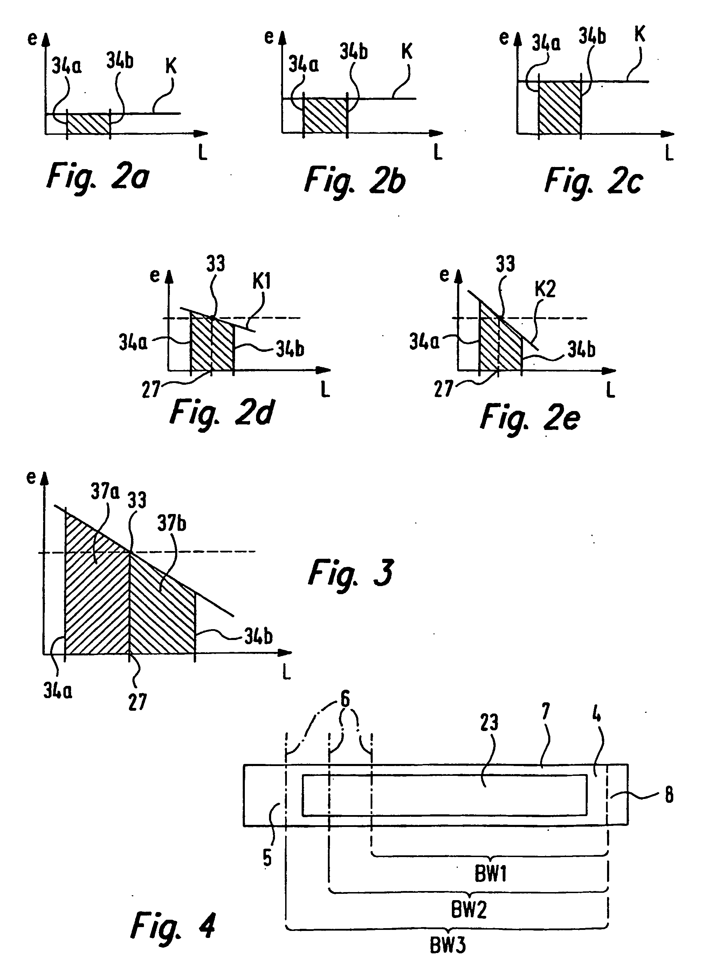

Betrachtet man die zwischen dem Befestigungsabschnitt 5 und dem Beaufschlagungsabschnitt 8 gemessene wirksame Biegeaktorlänge BW, so nimmt zwar mit zunehmender Betätigungsspannung und folglich mit zunehmender Auslenkung die Längsdehnung zu, ist jedoch jeweils über die gesamte wirksame Biegeaktorlänge BW hinweg konstant, solange der Befestigungsabschnitt 5 noch nicht auf den Widerstand 22 getroffen ist. In Fig. 2a, 2b und 2c wird dieser Umstand durch die zunehmend höher liegende horizontale Kennlinie K deutlich. In Fig. 2c, wie auch in Fig. 1c, vermittelt die horizontale Kennlinie K den Zustand praktisch unmittelbar vor dem Auftreffen auf den Widerstand 22 bzw. den diesen bildenden Ventilsitz 17.

Entsprechend einer zuvor vorgenommenen Kalibrierung kann somit anhand der durch die Sensoreinrichtung 23 ermittelten momentanen Dehnung das Maß der momentanen Auslenkung des Arbeitsabschnittes 7 und somit die Relativposition zwischen dem Beaufschlagungsabschnitt 8 und dem Widerstand 22 bzw. dem Ventilsitz 17 ermittelt werden.

Eine besondere Problematik ergibt sich jedoch durch den Umstand, dass die Längsdehnung des Arbeitsabschnittes 7 ab dem Moment des Auftreffens auf den Widerstand 22 über die wirksame Biegeaktorlänge BW hinweg keine Konstante mehr darstellt. Die Längsdehnung variiert insbesondere in Abhängigkeit von der Stellkraft, mit der der Arbeitsabschnitt 7 durch entsprechende Spannungsanlegung gegen den Widerstand 22 vorgespannt wird. Diese Stellkraft kann im Betrieb des Fluidsteuerventils variieren, insbesondere aufgrund von Schwankungen des über den Fluidkanal 18 auf den Beaufschlagungsabschnitt 8 einwirkenden Druckes. Entsprechend dem jeweiligen Belastungsfall ergeben sich stellkraftabhängig unterschiedlich stark gekrümmte Biegelinien des Biegeaktors 4, wobei in Fig. 1a bei BL1 und BL2 zwei solcher möglichen Biegelinien angedeutet sind. Die ebenfalls eingezeichnete Biegelinie BL3 repräsentiert schematisch eine Gestalt des Biegeaktors 4 im ausgelenkten, aber noch nicht gegen den Widerstand 22 vorgespannten Zustand.

Wie nun aber bei Berechnungen überraschend festgestellt wurde, verfügt der Biegeaktor 4 über eine ganz bestimmte Stelle, an der die Längsdehnung unabhängig davon konstant bleibt, mit welcher Stellkraft der Arbeitsabschnitt 7 gegen den Widerstand 22 drückt. Diese als Stelle konstanter Längsdehnung 27 bezeichnete Stelle liegt in Richtung der Längsachse 12 zwischen dem Befestigungsabschnitt 5 und dem Beaufschlagungsabschnitt 8, wobei sie zu beiden Abschnitten beabstandet ist. Beim Ausführungsbeispiel wird die wirksame Biegeaktorlänge BW durch die Stelle konstanter Längsdehnung 27 im Verhältnis 1/3 : 2/3 unterteilt, wobei der kürzere Abstand dem Befestigungsabschnitt 5 zugeordnet ist. Weitere Messungen haben ergeben, dass dieses spezielle Abstandsverhältnis in der Regel immer dann zutrifft, wenn die Einspannlänge des Biegeaktors 4 am Befestigungsabschnitt 5 im Verhältnis zur wirksamen Biegeaktorlänge BW klein ist.

Die Stelle konstanter Längsdehnung 27 kann beispielsweise unter Einsatz Finiter Elemente Methoden berechnet werden.

Die vorstehend geschilderte Erkenntnis wird erfindungsgemäß bei der Platzierung der Sensoreinrichtung 23 am Biegeaktor 4 ausgenutzt. Demnach sitzt die Sensoreinrichtung 23 an der Stelle konstanter Längsdehnung 27 und/oder in Längsrichtung symmetrisch beidseits dieser Stelle.

Idealerweise würde man die Sensoreinrichtung 23 auf die Stelle konstanter Längsdehnung 27 konzentrieren. Da diese Stelle jedoch punkt- oder linienförmig und somit in Richtung der Längsachse 12 sehr schmal ist, bedürfte es sehr kleiner und teurer Sensorstrukturen. Man verwendet daher zweckmäßigerweise eine Bauform, bei der sich die Sensoreinrichtung 23 über die Stelle konstanter Längsdehnung 27 hinweg erstreckt, sodass sie mit einem mittleren Abschnitt direkt an dieser Stelle konstanter Längsdehnung 27 liegt und zusätzlich mit zwei Sensorabschnitten 28a, 28b, die über die gleiche Länge verfügen, in Richtung der Längsachse 12 beidseits der Stelle konstanter Längsdehnung 27 in symmetrischer Weise zu liegen kommt. Bei der Dehnungsmessung neutralisieren sich die symmetrisch beidseits der Stelle konstanter Längsdehnung 27 gemessenen Dehnungsanteile, sodass letztlich die an der fraglichen Stelle 27 aktuell herrschende Längsdehnung erfassbar ist.

Die Sensoreinrichtung 23 kann in jeder geeigneten Bauart ausgeführt sein, die es ermöglicht, die Längsdehnung des Arbeitsabschnittes 7 an der mit der Sensoreinrichtung 23 bestückten Stelle zu erfassen. In der Regel wird es sich um eine Sensoreinrichtung 23 handeln, die auf kapazitivem oder ohmschem Messprinzip basiert. Vorteilhaft ist insbesondere die Ausgestaltung als Dehnungsmessstreifen.

Während sich also beim Ausführungsbeispiel die Sensoreinrichtung 23 durchgehend über die Stelle konstanter Längsdehnung 27 hinweg erstreckt, ist auch eine in Fig. 1b strichpunktiert angedeutete Bauform möglich, bei der die Sensoreinrichtung 23 im Bereich der Stelle konstanter Längsdehnung 27 eine Unterbrechung aufweist. In diesem Fall verfügt sie beispielsweise über zwei mit gleichem Abstand symmetrisch beidseits der Stelle konstanter Längsdehnung 27 platzierte Sensoreinrichtungsteile 32a, 32b, die die beiden Sensorabschnitte 28a, 28b bilden.

Möglich wäre auch eine durchgehende Sensoreinrichtung, bei der nach Art eines Spannungsteilers ein Mittenabgriff erfolgt.

In Fig. 1a ist strichpunktiert angedeutet, dass die Sensoreinrichtung 23 alternativ oder zusätzlich auch an der unteren Oberfläche 15 des Arbeitsabschnittes 7 platziert sein könnte. Durch die Mehrfachanordnung in mehreren in Dickenrichtung D beabstandeten Ebenen erhält man ein sich positiv auf die Präzision auswirkendes mehrfaches Sensorsignal.

Anstatt die Sensoreinrichtung 23 auf die Oberfläche des Arbeitsabschnittes 7 aufzusetzen - die Befestigung kann beispielsweise durch eine Klebeverbindung erfolgen -, wäre auch eine ganze oder teilweise Integration einer oder mehrerer Sensoreinrichtungen 23 in das Material des Biegeaktors 4 und/oder, bei einem Schichtaufbau desselben, zwischen die einzelnen Biegeaktorschichten möglich. Allerdings ist darauf zu achten, dass die eine oder mehreren Sensoreinrichtungen mit Abstand zur neutralen Faser des Biegeaktors 4 platziert werden, in der keinerlei Längsdehnung auftritt. Die Platzierung an der Außenoberfläche 14, 15 des Biegeaktors 4 hat den Vorteil, dass hier der Abstand zur neutralen Faser relativ groß ist und somit genauere Messergebnisse erzielt werden können.

Zurückkommend auf das Diagramm der Fig. 1c, sind dort strichpunktiert die den Biegelinien BL1 und BL2 entsprechenden Kennlinien dargestellt, bei denen es sich um Geraden handelt, die über unterschiedliche Steigungen verfügen, die jedoch beide in einem gemeinsamen Punkt mit der horizontalen Kennlinie K zusammentreffen, wobei dieser gemeinsame Punkt 33 die Längsdehnung e_{K} an der Stelle konstanter Längsdehnung 27 wiedergibt. Mit gleichem Abstand beidseits dieser Stelle 27 eingezeichnete vertikale Linien bilden Begrenzungslinien 34a, 34b, durch die die axial orientierten Enden der Sensoreinrichtung 23 markiert sind. Der zwischen den Begrenzungslinien 34a, 34b liegende Längenabschnitt LS gibt die Länge der Sensoreinrichtung 23 zwischen den einander entgegengesetzten äußeren Enden wieder.

Bei einem typischen Anwendungsfall der Aktoreinrichtung 1 und des in dieser enthaltenen Biegeaktors 4 wird zunächst, im Rahmen von Berechnungen oder Versuchen, der Wert der konstanten Längsdehnung e_{K} ermittelt. Diese Ermittlung geschieht zweckmäßigerweise durch Berechnung des Integrals unter den Kennlinien K1 und/oder K2 und/oder einer anderen dieser im Belastungsfall auftretenden Kennlinien, und zwar über die Länge der Sensoreinrichtung LS. In Fig. 1c ist exemplarisch das unter der Kennlinie K1 gebildete Integral durch eine Schraffur angedeutet.

Bei Aktivierung des Biegeaktors 4 wird durch die Auswertemittel 25, die über entsprechende Integriermittel 35 verfügen, das Integral unter der momentanen Kennlinie zwischen den beiden Begrenzungslinien 34a, 34b ermittelt. Gemäß Fig. 2a bis 2c ergibt sich eine Vergrößerung dieses Integrals mit zunehmender Betätigungsspannung und entsprechender Auslenkung des Arbeitsabschnittes 7. Die ermittelten Werte werden dann durch ebenfalls zu den Auswertemitteln 25 gehörende Vergleichermittel 36 mit dem durch die vorherige Kalibrierung ermittelten Sollwert des Integrals verglichen, der derjenigen Auslenkung entspricht, bei der der Arbeitsabschnitt 7 mit mehr oder weniger großer Kraft an den Widerstand 22 bzw. den Ventilsitz 17 angedrückt wird.

Wenn beispielsweise beabsichtigt ist, den Arbeitsabschnitt 7 so weit auszulenken, dass der Beaufschlagungsabschnitt 8 unter Verschluss des Fluidkanals 18 am Ventilsitz 17 anliegt, wird die Betätigungsspannung über die Zuleitungsmittel 16 so lange erhöht, bis das gemessene Integral dem Sollwert entspricht. Dabei ist von Vorteil, dass das ermittelte Integral von der Höhe der Stellkraft unabhängig ist. Aus Fig. 2d und 2e wird deutlich, dass ab dem Moment des Anliegens des Arbeitsabschnittes 7 am Widerstand 22 bei Variationen der Betätigungsspannung und folglich der Stellkraft nurmehr die Steigung der Kennlinie variiert, ohne dass sich die Lage des Punktes 33 verändert, sodass das ermittelte Integral konstant bleibt.

Somit kann die Auslenkposition des Arbeitsabschnittes 7 kraftunabhängig ermittelt werden. Bei einer bestimmten Auslenkung des Arbeitsabschnittes 7 ist die ermittelte Dehnung unabhängig von der herrschenden Kraft. Es ist somit möglich, unabhängig von der aufgebrachten Stellkraft mit hoher Präzision festzustellen, wenn der Biegeaktor 4 die gewünschte Auslenkung erreicht hat.

Bei der Integration macht man sich zunutze, dass sich beidseits der Stelle konstanter Längsdehnung 27 Bereiche linearer Dehnung befinden und somit präzise Aufsummierungen möglich sind.

Beim Ausführungsbeispiel besteht ferner die Möglichkeit, durch entsprechende Ausgestaltung der Sensoreinrichtung 23 die beidseits der Stelle konstanter Längsdehnung 27 liegenden Dehnungsteilintegrale 37a, 37b getrennt zu ermitteln. Besonders einfach ist dies bei einer Sensoreinrichtung 23, die sich aus mehreren separaten Sensoreinrichtungsteilen 32a, 32b zusammensetzt. Es besteht die Möglichkeit, durch anschließende Aufaddition der beiden Dehnungsteilintegrale 37a, 37b die zuvor geschilderte kraftunabhängige Erfassung der Auslenkung des Biegeaktors 4 vorzunehmen. Darüber hinaus besteht aber auch die Möglichkeit, die Dehnungsteilintegrale 37a, 37b voneinander zu subtrahieren, wobei das Resultat ein Maß für die Stellkraft ist, mit der der Biegeaktor 4 momentan gegen den Widerstand 22 drückt.

Indem man die Dehnungsteilintegrale 37a, 37b durch die entsprechend ausgestalteten Auswertemittel 25 sowohl addiert als auch subtrahiert, lässt sich der Biegeaktor 4 ohne weiteres so ansteuern, dass er den Widerstand 22 bei Erreichen der entsprechenden Auslenkung mit einer vorbestimmten Kraft beaufschlagt.

Insgesamt besteht somit die Möglichkeit, durch Dehnungsintegration über die gesamte Länge LS der Sensoreinrichtung 26 die Auslenkung des Biegeaktors 4 unabhängig von der externen Kraft zu ermitteln. Des Weiteren kann durch Subtraktion der Dehnungsteilintegrale die externe Kraft ermittelt werden. Auf diese Weise lässt sich eine Vielzahl von neuen Anwendungsfeldern für Biegeaktoren, insbesondere mit piezokeramischem Aufbau, erschließen.

Ein weiterer vorteilhafter Aspekt ergibt sich, wenn der Biegeaktor 4 mit einer Sensoreinrichtung 26 ausgestattet ist, die sich über eine längere Strecke erstreckt, wie dies in Fig. 4 angedeutet ist. Bei einer solchen Bauform lässt sich ein und derselbe Biegeaktor 4 für verschiedene Einsatzfälle konfigurieren, die sich durch die Position der Lagerstellen 6 am Befestigungsabschnitt 5 voneinander unterscheiden, sodass die wirksame Biegeaktorlänge verschieden sein kann, wie dies in Fig. 4 durch drei mögliche Biegeaktorlängen BW1, BW2 und BW3 illustriert ist.

Da sich die Position der Stelle konstanter Längsdehnung 27 an der wirksamen Biegeaktorlänge BW orientiert, ergeben sich bei den geschilderten Einsatzfällen unterschiedliche Positionen für die Stelle konstanter Längsdehnung 27. Die Sensoreinrichtung 23 ist nun aber so aufgebaut, dass sie sich in ihrer Längsrichtung selektiv deaktivieren lässt, indem man beispielsweise nicht erforderliche Längenabschnitte mittels eines Lasers oder eines anderen Trennwerkzeuges vom verbleibenden Anteil abtrennt. Somit kann die Sensoreinrichtung 23 in Abhängigkeit von der jeweils zutreffenden Stelle konstanter Längsdehnung 27 derart konfektioniert werden, dass sich die gewünschte Symmetrie zwischen den beidseits der Stelle konstanter Längsdehnung 27 befindlichen Abschnitten der Sensoreinrichtung 23 ergibt.

## Patentansprüche

1. Aktoreinrichtung, mit einem längliche Gestalt aufweisenden Biegeaktor (4), der mit einem Befestigungsabschnitt (5) an einem Grundkörper (2) der Aktoreinrichtung (1) fixiert ist und der über einen von dem Befestigungsabschnitt (5) wegragenden Arbeitsabschnitt (7) verfügt, der durch Aktivierung des Biegeaktors (4) quer zu dessen Längsachse (12) auslenkbar und gegen einen im Auslenkweg angeordneten Widerstand (22) drückbar ist und der mit mindestens einer zur Erfassung der Längsdehnung geeigneten Sensoreinrichtung (23) ausgestattet ist, **dadurch gekennzeichnet, dass** die Sensoreinrichtung (23) an und/oder in Längsrichtung symmetrisch beidseits einer Stelle (27) platziert ist, an der bei gegen den Widerstand (22) drückendem Arbeitsabschnitt (7) eine von der Stellkraft unabhängige, konstante Längsdehnung vorliegt.

2. Aktoreinrichtung nach Anspruch 1, **dadurch gekennzeichnet, dass** die Sensoreinrichtung (23) an einer der in der Richtung der Auslenkbewegung (13) orientierten Oberflächen (14, 15) platziert ist.

3. Aktoreinrichtung nach Anspruch 2, **gekennzeichnet durch** mehrere Sensoreinrichtungen (23), die in unterschiedlichen Ebenen am oder im Biegeaktor (4) platziert sind.

4. Aktoreinrichtung nach Anspruch 3, **dadurch gekennzeichnet, dass** an jeder der beiden in der Richtung der Auslenkbewegung (13) orientierten Oberflächen (14, 15) des Arbeitsabschnittes (7) jeweils mindestens eine Sensoreinrichtung (23) platziert ist.

5. Aktoreinrichtung nach einem der Ansprüche 1 bis 4, **dadurch gekennzeichnet, dass** sich die Sensoreinrichtung (23) durchgehend über die Stelle konstanter Längsdehnung (27) hinweg erstreckt.

6. Aktoreinrichtung nach einem der Ansprüche 1 bis 4, **dadurch gekennzeichnet, dass** die Sensoreinrichtung (23) im Bereich der Stelle konstanter Längsdehnung (27) unterbrochen ist.

7. Aktoreinrichtung nach einem der Ansprüche 1 bis 6, **dadurch gekennzeichnet, dass** die Sensoreinrichtung (23) auf kapazitivem Messprinzip basiert.

8. Aktoreinrichtung nach einem der Ansprüche 1 bis 6, **dadurch gekennzeichnet, dass** die Sensoreinrichtung (23) auf einem ohmschen Widerstandsmessprinzip basiert.

9. Aktoreinrichtung nach einem der Ansprüche 1 bis 8, **dadurch gekennzeichnet, dass** die Sensoreinrichtung (23) streifenförmig ausgebildet ist.

10. Aktoreinrichtung nach einem der Ansprüche 1 bis 9, **gekennzeichnet durch** eine Sensoreinrichtung (23), die sich über eine längere Strecke entlang dem Biegeaktor (4) erstreckt und die zur Anpassung an die sich anwendungsspezifisch ergebende Position der Stelle konstanter Längsdehnung (27) selektiv deaktiviert ist.

11. Aktoreinrichtung nach einem der Ansprüche 1 bis 10, **gekennzeichnet durch** eine Ausgestaltung des Biegeaktors (4) als Piezo-Biegewandler.

12. Aktoreinrichtung nach einem der Ansprüche 1 bis 11, **dadurch gekennzeichnet, dass** der Widerstand (22) von einem einem Fluidkanal (18) zugeordneten Ventilsitz (17) gebildet ist.

13. Aktoreinrichtung nach einem der Ansprüche 1 bis 12, **gekennzeichnet durch** eine Ausgestaltung als Fluidsteuerventil.

14. Aktoreinrichtung nach einem der Ansprüche 1 bis 13, **gekennzeichnet durch** Auswertemittel (25) zur Ermittlung der Auslenkung und/oder der Stellkraft des Arbeitsabschnittes (7) auf Basis der mit der Sensoreinrichtung (23) gemessenen Längsdehnung.

15. Aktoreinrichtung nach Anspruch 14, **dadurch gekennzeichnet, dass** die Auswertemittel (25) über Integriermittel (35) zur Bildung des Integrals der über die Messstreckenlänge der Sensoreinrichtung (23) auftretenden Längsdehnung sowie über Vergleichermittel (36) zum Vergleich des ermittelten Dehnungsintegrals mit einem vorgegebenen Sollwert aufweist.

16. Aktoreinrichtung nach Anspruch 14 oder 15, **dadurch gekennzeichnet, dass** die Auswertemittel (25) ausgebildet sind, um die Dehnungsintegrale der unter den beidseits der Stelle konstanter Längsdehnung (27) liegenden Abschnitte (28a, 28b) der Sensoreinrichtung (23) getrennt voneinander zu ermitteln und um die ermittelten Dehnungsintegrale zu addieren und/oder zu substrahieren.

## Claims

1. Actuator device with a bending actuator (4) of elongated shape, which is fixed to a framework (2) of the actuator device (1) by a fastening section (5) and which has an operating section (7) extending away from the fastening section (5) which, through activation of the bending actuator (4), may be deflected at right-angles to its longitudinal axis (12) and pressed against a resistor (22) located in the deflection path, and which is equipped with one or more sensor devices (23) suitable for detection of the linear extension, **characterised in that** the sensor device (23) is placed at, and/or in the longitudinal direction symmetrically either side of, a point (27) at which there is constant linear extension, irrespective of the adjusting force, when the operating section (7) presses against the resistor (22).

2. Actuator device according to claim 1, **characterised in that** the sensor device (23) is placed on one of the surfaces (14, 15) oriented in the direction of the deflection movement (13).

3. Actuator device according to claim 2, **characterised by** several sensor devices (23) placed in different planes on or in the bending actuator (4).

4. Actuator device according to claim 3, **characterised in that** at least one sensor device (23) is placed on each of the surfaces (14, 15) of the operating section (7) oriented in the direction of the deflection movement (13).

5. Actuator device according to any of claims 1 to 4, **characterised in that** the sensor device (23) extends continuously over the point of constant linear extension (27).

6. Actuator device according to any of claims 1 to 4, **characterised in that** the sensor device (23) is interrupted in the area of the point of constant linear extension (27).

7. Actuator device according to any of claims 1 to 6, **characterised in that** the sensor device (23) is based on the capacitive measuring principle.

8. Actuator device according to any of claims 1 to 6, **characterised in that** the sensor device (23) is based on an ohmic resistance measuring principle.

9. Actuator device according to any of claims 1 to 8, **characterised in that** the sensor device (23) is strip-like in form.

10. Actuator device according to any of claims 1 to 9, **characterised by** a sensor device (23) which extends over a longer section along the bending actuator (4), and is selectively deactivated to adjust to the position of the point of constant linear extension (27) resulting from the specific application.

11. Actuator device according to any of claims 1 to 10, **characterised by** design of the bending actuator (4) as a piezo bending actuator.

12. Actuator device according to any of claims 1 to 11, **characterised in that** the resistor (22) is formed by a valve seat (17) assigned to a fluid passage (18).

13. Actuator device according to any of claims 1 to 12, **characterised by** design as a fluid control valve.

14. Actuator device according to any of claims 1 to 13, **characterised by** evaluation means (25) to determine the deflection and/or the adjusting force of the operating section (7) on the basis of the linear extension measured by the sensor device (23).

15. Actuator device according to claim 14, **characterised in that** the evaluation means (25) have integrating means (35) to form the integral of the linear extension occurring over the measuring length of the sensor device (23), and comparison means (36) for comparing the determined extension integrals with a preset required value.

16. Actuator device according to claim 14 or 15, **characterised in that** the evaluation means (25) are designed to determine the extension integrals of the sections (28a, 28b) of the sensor device (23) lying either side of the point of constant linear extension (27) separately from one another, and to add and/or subtract the extension integrals determined.

## Revendications

1. Dispositif d'actionnement comportant un actionneur à flexion (4) présentant une forme allongée qui est fixé par une portion de fixation (5) à un corps de base (2) du dispositif d'actionnement (1) et qui possède une portion de travail (7), partant de la portion de fixation (5), qui peut être déviée par activation de l'actionneur à flexion (4) transversalement à son axe longitudinal (12) et qui peut être pressée à l'encontre d'une résistance (22) disposée dans la voie de déviation et qui est équipée d'au moins un dispositif de détection (23) propre à détecter l'allongement, **caractérisé en ce que** le dispositif de détection (23) est placé sur et/ou dans la direction longitudinale symétriquement de part et d'autre d'un emplacement (27) qui présente un allongement constant, indépendant de la force de réglage, lorsque la portion de travail (7) presse à l'encontre de la résistance (22).

2. Dispositif d'actionnement selon la revendication 1, **caractérisé en ce que** le dispositif de détection (23) est placé sur l'une des surfaces (14, 15) orientées dans la direction du mouvement de déviation (13).

3. Dispositif d'actionnement selon la revendication 2, **caractérisé par** plusieurs dispositifs de détection (23) qui sont placés dans différents plans sur ou dans l'actionneur à flexion (4).

4. Dispositif d'actionnement selon la revendication 3, **caractérisé en ce que** sur chacune des deux surfaces (14, 15) de la portion de travail (7), orientées dans la direction du mouvement de déviation (13), il est placé au moins un dispositif de détection (23) respectif.

5. Dispositif d'actionnement selon l'une des revendications 1 à 4, **caractérisé en ce que** le dispositif de détection (23) s'étend de manière continue sur l'emplacement d'allongement constant (27).

6. Dispositif d'actionnement selon l'une des revendications 1 à 4, **caractérisé en ce que** le dispositif de détection (23) est interrompu dans la zone de l'emplacement d'allongement constant (27).

7. Dispositif d'actionnement selon l'une des revendications 1 à 6, **caractérisé en ce que** le dispositif de détection (23) se fonde sur un principe de mesure capacitif.

8. Dispositif d'actionnement selon l'une des revendications 1 à 6, **caractérisé en ce que** le dispositif de détection (23) se fonde sur un principe de mesure de résistance ohmique.

9. Dispositif d'actionnement selon l'une des revendications 1 à 8, **caractérisé en ce que** le dispositif de détection (23) est réalisé en forme de bande.

10. Dispositif d'actionnement selon l'une des revendications 1 à 9, **caractérisé par** un dispositif de détection (23) qui s'étend sur une distance assez longue le long de l'actionneur à flexion (4) et qui est désactivé de manière sélective pour l'adaptation à la position, spécifique à l'application, de l'emplacement d'allongement constant (27).

11. Dispositif d'actionnement selon l'une des revendications 1 à 10, **caractérisé par** une réalisation de l'actionneur à flexion (4) sous la forme d'un piézoconvertisseur à flexion.

12. Dispositif d'actionnement selon l'une des revendications 1 à 11, **caractérisé en ce que** la résistance (22) est formée par un siège de soupape (17) associé à un canal pour fluide (18).

13. Dispositif d'actionnement selon l'une des revendications 1 à 12, **caractérisé par** une forme de réalisation en tant que soupape de commande de fluide.

14. Dispositif d'actionnement selon l'une des revendications 1 à 13, **caractérisé par** des moyens d'exploitation (25) pour déterminer la déviation et/ou la force de réglage de la portion de travail (7) sur la base de l'allongement mesuré à l'aide du dispositif de détection (23).

15. Dispositif d'actionnement selon la revendication 14, **caractérisé en ce que** les moyens d'exploitation (25) comportent des moyens d'intégration (35) pour former l'intégrale de l'allongement survenant sur la longueur du parcours de mesure du dispositif de détection (23), ainsi que des moyens de comparaison (36) pour la comparaison de l'intégrale d'allongement déterminée à une valeur de consigne prédéfinie.

16. Dispositif d'actionnement selon la revendication 14 ou 15, **caractérisé en ce que** les moyens d'exploitation (25) sont conçus pour déterminer séparément l'une de l'autre les intégrales d'allongement des portions (28a, 28b) du dispositif de détection (23), situées des deux côtés sous l'emplacement d'allongement constant (27), et pour additionner et/ou soustraire les intégrales d'allongement déterminées.
